Europäisches Patentamt

European Patent Office

Office européen des brevets

(19)

(11) Veröffentlichungsnummer: **0 303 079**
**A2**

## (12) EUROPÄISCHE PATENTANMELDUNG

(21) Anmeldenummer: 88111724.6

(22) Anmeldetag: 20.07.88

(51) Int. Cl.⁴: **H01L 29/40 , H01L 29/80**

(30) Priorität: 11.08.87 DE 3726717

(43) Veröffentlichungstag der Anmeldung:
15.02.89 Patentblatt 89/07

(84) Benannte Vertragsstaaten:
DE FR GB

(71) Anmelder: **Siemens Aktiengesellschaft Berlin
und München
Wittelsbacherplatz 2
D-8000 München 2(DE)**

(72) Erfinder: **Willer, Josef, Dr.·
Hirschplanallee 3
D-8042 Oberschleissheim(DE)**

(54) **Halbleiterbauelement mit hochtemperaturstabilem Schottky-Kontakt.**

(57) Halbleiterbauelement mit hochtemperaturstabilem Schottky-Kontakt, bestehend aus einer Wolfram-Bor-Legierung hohen Schmelzpunktes, die amorph abgeschieden wird und während des Temperprozesses eine stabile Schottky-Barriere beibehält, wobei die physikalischen Eigenschaften des Schottky-Kontaktes erhalten bleiben und eine besonders hohe Barrierewirkung gegen Materialdiffusion erzielt wird.

EP 0 303 079 A2

## Halbleiterbauelement mit hochtemperaturstabilem Schottky-Kontakt

Gegenstand der vorliegenden Erfindung ist ein Halbleiterbauelement mit den Merkmalen des Oberbegriffes des Anspruchs 1.

Hochtemperaturstabile Schottky-Kontakte sind für die Gate-Metallisierung zur Herstellung von selbstjustierten GaAs-MESFETs erforderlich. Um die Source- und Drain-Bereiche selbstjustiert auszubilden, wird bei den gängigen Verfahren das Gate-Metall, das mit dem Halbleitermaterial des herzustellenden MESFETs einen Schottky-Übergang bildet, vor der $n^+$-Ionenimplantation aufgebracht und strukturiert, wobei das Gate als Implantationsmaske dient. Nach dem Ausbilden der Source- und Drain-Bereiche wird die Dotierung aktiviert durch Erwärmen auf mindestens 800°C 20 Minuten lang oder bei Kurzzeit-Ausheilung (flash anneal) 900°C 15 Sekunden lang. Bei dieser Wärmebehandlung müssen die elektrischen Eigenschaften des Schottky-Kontaktes erhalten bleiben. Die wesentlichen elektrischen Eigenschaften sind die Höhe des elektrischen Potentials an der Grenze zwischen Metall und Halbleiter (Barrierenhöhe), die Durchbruchspannung in Sperrichtung und der Idealitätsfaktor. Dieser Idealitätsfaktor beschreibt die Abweichung der Schottky-Diode vom idealen Verhalten, das durch die Gleichung

$$I = I_s \left( \exp \frac{e\,V}{n\,k\,T} - 1 \right)$$

beschrieben wird. Dabei ist I der Strom, V die angelegte Spannung, die in Flußrichtung positiv gezählt wird, e die Elementarladung, k die Boltzmannkonstante, T die Temperatur in Kelvin, $I_s$ der Sättigungsstrom in Sperrichtung und n der Idealitätsfaktor. Bei einer idealen Schottky-Diode gilt n = 1. Bei dem Gate eines MESFET soll der Idealitätsfaktor nicht mehr als 1,4 betragen. Abgesehen von dem Erhalt der elektrischen Eigen schaften ist es insbesondere wesentlich, daß der Metall-Halbleiter-Kontakt bei dem Temperprozeß auch eine hinreichend hohe Barrierewirkung gegen Materialdiffusion beibehält, um Eindiffusion von Metallatomen in das Halbleitermaterial und umgekehrt Ausdiffusion von Elementen aus dem Halbleitermaterial in das Metall des Gates zu verhindern.

In der US-PS 4 566 021 ist ein hochtemperaturstabiler Schottky-Kontakt für eine Gate-Metallisierung auf der Basis eines Metallsilizides beschrieben. Als Metalle sind insbesondere Titan, Wolfram, Molybdän und Tantal genannt. In der US-PS 4 574 298 ist ein entsprechender Schottky-Kontakt unter Verwendung von Metallnitriden mit hohem Schmelzpunkt mit Metall aus den Gruppen IV, V und VI des Periodensystems beschrieben. Als Metalle werden insbesondere genannt Wolfram, Tantal, Molybdän, Titan, Zirkon, Niob und Vanadium. In der US-PS 4 586 063 wird als Material eine Legierung aus Wolfram und Aluminium angegeben, wobei der Anteil an Aluminium zwischen 0.5 und 3 Atomprozent liegt. Im Stand der Technik sind des weiteren Titan-Wolfram-Legierungen, reines Wolfram und das Aufbringen von zusätzlichen Schichten aus reinen Metallen wie Molybdän und Wolfram bei Wolframsiliziden und Wolframnitriden beschrieben. Wolframsilizide und Wolframnitride besitzen einen hohen spezifischen Widerstand; um eine hinreichend hohe elektrische Leitfähigkeit der Gate-Metallisierung sicherzustellen, wird daher auf eine relativ dünne Schicht des Silizides bzw. Nitrides eine im Vergleich dazu hohe streifenförmige Schicht aus reinem Metall aufgebracht.

In der Druckschrift von Y. Uchida e. a.: "Study of Thermal Stability of $LaB_6$ and GaAs Interfaces by High Energy Ion Scattering" in Jpn. J. Appl. Phys. 25, L767-L769 (1986) wird als Material zur Herstellung hochtemperaturstabiler Schottky-Kontakte $LaB_6$ angegeben. Die Autoren nennen dabei als Vorzüge dieses Materials thermische Stabilität, hervorragende elektrische Eigenschaften, leichte Verarbeitbarkeit und gute Verbundeigenschaften mit GaAs-Trägern. Als Temperatur für den Ausheilungsprozeß, den dieses Kontaktmaterial überstehe, ist 850°C angegeben.

In der Druckschrift von Y. Uchida e.a.: "Electrical properties of thermally stable $LaB_6$ GaAs Schottky diodes" sind Meßreihen von elektrischer Barrierenhöhe und Idealitätsfaktor für $LaB_6$-Kontaktschichten auf oxidfreiem GaAs und auf chemisch geätztem GaAs bei Ausheilzyklen bis 850°C angegeben. Im Fall des chemisch geätzten GaAs-Substrats fällt die Barrierenhöhe für das Ausheilen bei Temperaturen über 750°C ab. Für den Fall, daß das $LaB_6$-Material auf einer reinen GaAs-Oberfläche abgeschieden worden ist, geben die Autoren eine Barrierenhöhe von mehr als 0,85 eV an. Der Idealitätsfaktor liegt in beiden Fällen nach dem Ausheilen bei Werten zwischen 1,05 und 1.2.

In der Druckschrift von M. Suzuki e.a.: "Advantages of Metallic-Amorphous-Silicon-Gate-FET's in GaAs LSI Applications" wird als Material für die Schottky-Kontaktschicht amorphes Silizium-Germanium-Bor angegeben, womit eine Barrierenhöhe von 1 eV erreicht wird. Dieser Schottky-Kontakt wurde erst nach dem Ausheilen der Dotierung aufgebracht. Das Metall der Elektrode wurde 1 Minute lang bei 450°C einlegiert.

Selbstjustierende Prozesse, die ohne hochtemperaturstabile Gate-Metallisierung auskommen, sind zwar ebenfalls bekannt; sie benötigen jedoch ein Pseudo-Gate (Dummy-Gate), das später im Verlauf des Prozesses durch das Gate-Metall ersetzt wird. Damit verbunden ist die Problematik, daß in der Regel vor dem Metallabscheiden ein Dielektrikum abgeätzt werden muß, was sich ungünstig auf die zu erzielende elektrische Barrierenhöhe des fertigen Schottky-Kontakts auswirkt, so daß meistens vor dem Abscheiden des Gate-Metalls zusätzlich der GaAs-Kristall im Oberflächenbereich schonend abgeätzt wird, um die volle Barrierenhöhe zu erreichen.

Aufgabe der vorliegenden Erfindung ist es, ein Halbleiterbauelement anzugeben, das einen Metall-III-V-Halbleiter-Kontakt aus einem Material aufweist, das eine besonders hohe Barrierewirkung gegen Materialdiffusion besitzt und so beschaffen ist, daß im Fall eines Schottky-Kontaktes die elektrischen Eigenschaften, im wesentlichen die elektrische Barrierenhöhe, die Durchbruchspannung in Sperrichtung und der Idealitätsfaktor, durch den Temperaturzyklus zum Ausheilen von Ionenimplantation nicht beeinträchtigt werden, wobei Temperaturen und Zeitdauern im Bereich von 840° C und mindestens 20 Minuten bis 900° C und mindestens 15 Sekunden zur Anwendung gelangen.

Diese Aufgabe wird bei einer erfindungsgemäßen Anordnung durch die Merkmale des Anspruchs 1 gelöst.

Auf der Oberfläche eines Halbleiterbauelementes aus III-V-Material, ist ein Schottky-Kontakt, z.B. für die Ansteuerung des Gates eines MESFET, aus einer Legierung aus einem Übergangsmetall und Bor aufgebracht. Dabei handelt es sich um eine Mischung, in der das Metall und das Bor und/oder verschiedene quasi als Verbindung vorliegende stöchiometrische Metall-Bor-Zusammensetzungen jeweils in durch den Herstellungsprozeß bedingten Anteilen vorliegen. Dabei soll nicht ausgeschlossen sein, daß in der Metall-Bor-Legierung übliche und bei der Herstellung nicht vollständig beseitigte Begleitelemente des Bor und der betreffenden Übergangsmetalle in die Funktionsfähigkeit eines erfindungsgemäßen Aufbaus nicht beeinträchtigender Menge enthalten sind. Boride zählen zu den thermisch und chemisch sehr stabilen Stoffen und sind insbesondere gegen Oxidation beständig. Bor hat einen relativ hohen Schmelzpunkt von ungefähr 2300° C. Daher hat auch die Metall-Bor-Legierung bei Verwendung hochschmelzender Metalle einen hohen Schmelzpunkt.

Der hohe Schmelzpunkt ist einerseits erforderlich, damit das Material hitzebeständig ist; andererseits wird eine amorphe Legierung mit hohem Schmelzpunkt bei der Temperatur, bei der der Ausheilprozeß stattfindet, amorph bleiben. Ist das mit dem Bor legierte Metall ein solches, das beim Aufbringen des Schottky-Kontaktes amorph bleibt, so wird es auch beim Tempern amorph bleiben, weil die Kristallisationstemperatur empirisch bei etwa 2.3 Schmelztemperatur liegt. Wegen des kleinen Atomradius ist Bor besonders geeignet, den amorphen Zustand einer Metall-Bor-Legierung zu stabilisieren, wenn die Boratome die Lücken zwischen den Metallatomen auffüllen.

Der amorphe Zustand der Legierung hat für die Barrierewirkung gegen Materialausdiffusion entscheidende Vorteile. Die meisten Metalle, aber auch Metallegierungen weisen eine relativ niedrige Kristallisationstemperatur auf, so daß sie häufig bereits im abgeschiedenen, ungetemperten Zustand polykristallin vorliegen. Sie weisen deshalb Korngrenzen auf, die regelrecht als Diffusionskanäle wirken können, sofern sie nicht gezielt durch Fremdatome chemisch abgesättigt werden (sog. stuffed barriers). Ein noch günstigerer Fall als die abgesättigten Korngrenzen liegt vor, wenn das Material des Schottky-Kontakts amorph ist, da dann überhaupt keine Korngrenzen vorhanden sind. Der Transportmechanismus der Korngrenzendiffusion spielt dann keine Rolle mehr; eine Ausdiffusion von Atomen aus dem Halbleitermaterial ist damit drastisch erschwert.

Die Barrierewirkung bei Verwendung des Bor ist bei einem Substrat aus GaAs besonders hoch, weil sich Bor und Gallium nicht mischen, also die Ausdiffusion von Gallium in Bor stark erschwert ist.

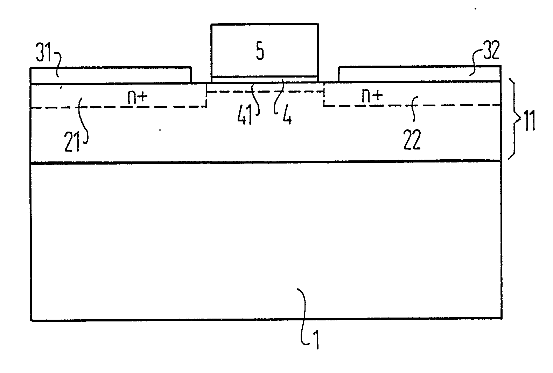

Eine spezielle Ausgestaltung eines erfindungsgemäßen Schottky-Kontaktes wird anhand der Figur, die einen Schnitt durch einen MESFET quer zur Längsrichtung des Gates zeigt, beschrieben.

In einer auf einem Substrat 1 epitaktisch aufgewachsenen Heteroschichtstruktur 11 aus III-V-Halbleitermaterial, hier GaAs, sind Source-Bereich 21 und Drain-Bereich 22 selbstjustiert ausgebildet und jeweils mit zugehörigem Source-Kontakt 31 und Drain-Kontakt 32 versehen. Source- und Drain-Bereiche 21, 22 sind stark n-leitend dotiert. Die Gate-Metallisierung 4, 5 besteht aus der den eigentlichen Schottky-Kontakt 41 bildenden streifenförmigen amorph abgeschiedenen $W_{73}B_{27}$-Legierung und der auf der Wolfram-Bor-Schicht 4 streifenförmig aufgebrachten Gate-Elektrode 5 aus Molybdän oder Wolfram, um eine für die Ansteuerung hinreichend hohe elektrische Leitfähigkeit der Gate-Metallisierung sicherzustellen.

Das Zweistoff-Zustandsdiagramm von Bor und Wolfram weist bei einem Verhältnis von 27 Atomprozent Bor ein Eutektikum mit einer Schmelztemperatur von 2600° C auf. Diese Schmelztemperatur ist so hoch, daß die Amorphie der Wolfram-Bor-Schicht 4 bei einem Temperprozeß bei 840° C bzw. bei Kurzzeit-Ausheilung von 900° C erhalten bleibt. Das Material der Metall-Bor-Schicht 4 ist folglich bei dem fertigen Bauelement amorph. Damit ist die gute Barrierewirkung des Schottky-Kontaktes 41 erzielt. Durch die Verwendung von GaAs als Halbleitermaterial wird diese Barrierewirkung wegen der fehlenden Mischbarkeit der Elemente Bor und Gallium noch erheblich verstärkt. Bei dem angegebenen prozentualen Anteil von Bor besteht die Metall-Bor-Schicht 4 auch volumenmäßig überwiegend aus Wolframatomen. Die Boratome füllen die Lücken zwischen den Wolframatomen aus und stabilisieren den amorphen Zustand.

**Ansprüche**

1. Halbleiterbauelement mit Metall-III-V-Halbleiter-Kontakt (41), dessen elektrische Eigenschaften sich durch den Temperzyklus zum Ausheilen von Dotierung, wobei Temperaturen und Zeitdauern im Bereich von 840° C und mindestens 20 Minuten bis 900° C und mindestens 15 Sekunden zur Anwendung gelangen, nicht mehr als für die beabsichtigte Funktion tolerierbar verändern,
**dadurch gekennzeichnet,**
daß der Metall-III-V-Halbleiter-Kontakt (41) mit einer Kontaktschicht (4) aus einem Material, das im wesentlichen aus Bor und mindestens einem Übergangsmetall, ausgenommen Lanthan, besteht, gebildet ist.

2. Halbleiterbauelement nach Anspruch 1 mit Substrat (1) und epitaktisch aufgewachsener Heteroschichtstruktur (11),
**dadurch gekennzeichnet,**
daß das Substrat (1) und die Heteroschichtstruktur (11) aus mehreren Halbleitermaterialien der Gruppe GaAs, GaAlAs, GaInAs, GaInP, InP, InGaAsP gebildet ist.

3. Halbleiterbauelement nach Anspruch 1,
**dadurch gekennzeichnet,**
daß das Halbleitermaterial GaAs ist.

4. Halbleiterbauelement nach einem der Ansprüche 1 bis 3,
**dadurch gekennzeichnet,**
daß der Metall-Halbleiter-Kontakt (41) direkt auf dem Substrat (1) aufgebracht ist.

5. Halbleiterbauelement nach Anspruch 1 oder 2,
**dadurch gekennzeichnet,**
daß das Material der Kontaktschicht (4) keine intermetallische Verbindung ist.

6. Halbleiterbauelement nach einem der Ansprüche 1 bis 3,
**dadurch gekennzeichnet,**
daß der Metall-Halbleiter-Kontakt (41) ein sperrender Schottky-Kontakt ist.

7. Halbleiterbauelement nach einem der Ansprüche 1 bis 4,
**dadurch gekennzeichnet,**
daß das Material der Kontaktschicht (4) aus Bor und Wolfram besteht.

8. Halbleiterbauelement nach einem der Ansprüche 1 bis 5,
**dadurch gekennzeichnet,**
daß das Material der Kontaktschicht (4) einen Schmelzpunkt von mindestens 2300° C aufweist.

9. Halbleiterbauelement nach einem der Ansprüche 1 bis 6,
**dadurch gekennzeichnet,**
daß das Material der Kontaktschicht (4) amorph abgeschieden ist.

31    5    32

n+    41    4    n+    11

21    22

1